(19) Europäisches Patentamt
European Patent Office
Office européen des brevets

(11) **EP 3 869 539 B1**

(12) **EUROPEAN PATENT SPECIFICATION**

(45) Date of publication and mention
of the grant of the patent:
**30.10.2024 Bulletin 2024/44**

(21) Application number: **19873214.1**

(22) Date of filing: **02.10.2019**

(51) International Patent Classification (IPC):
*H01L 21/336* (2006.01)  *C01B 32/159* (2017.01)
*C01B 32/174* (2017.01)  *H01L 29/786* (2006.01)
*H10K 19/10* (2023.01)  *H10K 10/46* (2023.01)
*H10K 71/10* (2023.01)

(52) Cooperative Patent Classification (CPC):
**C01B 32/174; C01B 32/159; H10K 19/10;
H10K 71/10;** H10K 10/484

(86) International application number:
**PCT/JP2019/038919**

(87) International publication number:
**WO 2020/080109 (23.04.2020 Gazette 2020/17)**

(54) **PRODUCTION METHOD FOR FIELD-EFFECT TRANSISTOR AND PRODUCTION METHOD FOR WIRELESS COMMUNICATION DEVICE**

HERSTELLUNGSVERFAHREN FÜR FELDEFFEKTTRANSISTOR UND HERSTELLUNGSVERFAHREN FÜR EIN DRAHTLOSES KOMMUNIKATIONSGERÄT

PROCÉDÉ DE PRODUCTION DE TRANSISTOR À EFFET DE CHAMP ET PROCÉDÉ DE PRODUCTION DE DISPOSITIF DE COMMUNICATION SANS FIL

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **18.10.2018 JP 2018196506**

(43) Date of publication of application:
**25.08.2021 Bulletin 2021/34**

(73) Proprietor: **Toray Industries, Inc.
Tokyo 103-8666 (JP)**

(72) Inventors:
• **SHIMIZU, Hiroji**
**Otsu-shi, Shiga 520-8558 (JP)**
• **HORII, Shinji**
**Otsu-shi, Shiga 520-8558 (JP)**
• **MURASE, Seiichiro**
**Otsu-shi, Shiga 520-8558 (JP)**

(74) Representative: **Hoefer & Partner Patentanwälte mbB
Pilgersheimer Straße 20
81543 München (DE)**

(56) References cited:
JP-A- 2006 261 423    JP-A- 2009 239 178
JP-A- 2013 021 289

• **SATOSHI ISHII ET AL: "Fabrication of Thin-Film Transistor Integrated Circuits on Flexible Substrate by Transfer Technique of Carbon Nanotube Network Using Poly(vinyl alcohol)", JAPANESE JOURNAL OF APPLIED PHYSICS, JAPAN SOCIETY OF APPLIED PHYSICS, JP, vol. 52, no. 10/1, 1 October 2013 (2013-10-01), pages 108001 - 1, XP001590170, ISSN: 0021-4922, [retrieved on 20130909], DOI: 10.7567/JJAP.52.108001**

**Description**

TECHNICAL FIELD

The present invention relates to a method of producing field-effect transistors and a method of producing a wireless communication device.

BACKGROUND ART

In recent years, wireless communication systems using RFID (Radio Frequency IDentification) technology have been attracting attention. An RFID tag has: an IC chip having a circuit including a field-effect transistor (hereinafter referred to as an FET); and an antenna for wireless communication with reader/writers. The antenna mounted in the tag receives carrier waves transmitted from readers/writers and thus operates a drive circuit in the IC chip.

RFID tags are expected to be utilized in various applications such as logistics management, merchandise management, shoplifting prevention, and the like, and have started being introduced in some of the applications, for example, merchandise tags and IC cards such as transportation cards.

For an RFID tag to be used for every kind of merchandise in the future, the production costs of such a tag need to be decreased. In view of this, studies have been made on flexible and inexpensive tags based on getting rid of production processes that use vacuum and high temperature and on using coating and printing technologies.

For example, for a circuit in an IC chip, FET in which an organic semiconductor or carbon nanotubes having excellent formability is/are used as a semiconductor layer has been proposed. Utilizing an organic semiconductor or carbon nanotubes as ink makes it possible to form a circuit pattern directly on a flexible substrate using inkjet technology, screen printing technology, and the like. In this regard, FETs in which organic semiconductors or carbon nanotubes are used in place of conventional inorganic semiconductors are vigorously studied (see, for example, Patent Literature 1).

On the other hand, permitting an FET constituting a circuit in an IC chip to generate an electrical characteristic variation (for example, a variation in the driving current value) makes it difficult to achieve stable circuit operation according to the design specification. Because of this, in order to inhibit the variation in the driving current value of an FET among the FET elements, studies are being made on, for example, a structure in which the channel is split into a plurality of regions (see, for example, Patent Literature 2). In this method, the variation in the driving current value of an FET is inhibited by forming a channel with a plurality of regions to level the variation in the channel width when the channel is formed in a semiconductor layer.

In addition, studies are being made on a method in which, to inhibit such a variation in the driving current value of an FET as is caused by a deviation of the pattern due to the deformation of the substrate or to the like, the exposure data on a source electrode and drain electrode of the FET are corrected, with the channel length fixed, on the basis of a strain in the substrate or the ratio of expansion and shrinkage of the substrate (see, for example, Patent Literature 3). Even with a flexible substrate, this method inhibits the variation in the channel length to thereby decrease the variation in the driving current value of an FET.

SATOSHI ISHII ET AL, "Fabrication of Thin-Film Transistor Integrated Circuits on Flexible Substrate by Transfer Technique of Carbon Nanotube Network Using Poly(vinyl alcohol)", JAPANESE JOURNAL OF APPLIED PHYSICS, JAPAN SOCIETY OF APPLIED PHYSICS, JP, vol. 52, no. 10/1, doi:10.7567/JJAP.52.108001, ISSN 0021-4922, (20131001), pages 108001 - 1, (20130909), XP001590170 discloses flexible integrated circuits consisting of carbon nanotube thin-film transistors (CNTTFTs) being fabricated on a poly(ethylene naphthalate) (PEN) substrate by a transfer technique of a CNT network. The CNT network grown on a $SiO_2/p^+$-Si substrate by plasma-enhanced chemical vapor deposition is transferred onto the PEN substrate using poly(vinyl alcohol) (PVA). A delay time of 1.1 $\mu$s/gate was realized for a ring oscillator with a channel length of 10 $\mu$m.

Citation List

Patent Literature

    Patent Literature 1: WO2009/139339 A1
    Patent Literature 2: JP2006-261423A
    Patent Literature 3: JP2012-212722A

SUMMARY OF INVENTION

Technical Problem

Although the method described in Patent Literature 2 makes it possible to inhibit such a variation in the electric current value due to a variation in the channel width, however, the method poses, for example, a problem in that the method does not make it possible to inhibit a variation due to another factor such as a production variation in the channel length or a variation in the thickness of the gate insulating layer.

The method described in Patent Literature 3 makes it possible to correct a strain in a substrate, but poses a problem in that the method does not make it possible to inhibit, for example, such a variation in the channel width or channel length as is due to a production variation caused while electrodes are formed.

In view of the above-mentioned problems, an object of the present invention is to provide an FET having inhibited characteristic variation and a method of producing such an FET in an easy and convenient manner.

Solution to Problem

To solve the above-mentioned problems, the present invention includes the below-mentioned producing methods. That is, the present invention includes a method of producing a plurality of field-effect transistors on the surface of a substrate, the method including

forming a plurality of structures containing at least one or more of a gate electrode, a gate insulating layer, a source electrode, and a drain electrode, followed by the steps of:

> (A1) in each of the plurality of structures, measuring a physical quantity based on the one or more of the formed gate electrode, gate insulating layer, source electrode, and drain electrode;
> (B1) on the basis of the measured physical quantity in each of the structures, adjusting the coating quantity of a semiconductor material to be applied to each of the structures; and
> (C1) applying the semiconductor material in the adjusted coating quantity to the plurality of structures.

In another aspect, a method of producing a plurality of field-effect transistors according to the present invention includes

forming a plurality of structures containing a gate electrode and a gate insulating layer, followed by the steps of:

> (A2) in each of the plurality of structures, measuring a physical quantity based on the one or more of the formed gate electrode and gate insulating layer;
> (B2) on the basis of the measured physical quantity in each of the structures, adjusting the coating quantity of a semiconductor material to be applied to each of the structures;
> (C2) applying the semiconductor material in the adjusted coating quantity to the plurality of structures; and
> (D2) forming a source electrode and a drain electrode.

In still another aspect, a method of producing a plurality of field-effect transistors according to the present invention includes

forming a plurality of structures containing a source electrode and a drain electrode, followed by the steps of:

> (A3) in each of the plurality of structures, measuring a physical quantity based on the one or more of the formed source electrode and drain electrode;
> (B3) on the basis of the measured physical quantity in each of the structures, adjusting the coating quantity of a semiconductor material to be applied to each of the structures;
> (C3) applying the semiconductor material in the adjusted coating quantity to the plurality of structures; and
> (D3) forming a gate electrode and a gate insulating layer.

Advantageous Effects of Invention

The present invention makes it possible to produce an FET the transistor characteristics of which are inhibited from varying owing to a variation (variable factor) generated in production processes.

BRIEF DESCRIPTION OF DRAWINGS

FIG. 1A is schematic sectional views depicting an example of a method of producing a field-effect transistor according to a first embodiment of the present invention.

FIG. 1B is a schematic top view depicting a field-effect transistor formed using a method of producing a field-effect transistor according to the first embodiment of the present invention.

FIG. 2 is schematic sectional views depicting an example of a method of producing a field-effect transistor according to a second embodiment of the present invention.

FIG. 3 is schematic sectional views depicting an example of a method of producing a field-effect transistor according to a third embodiment of the present invention.

DESCRIPTION OF EMBODIMENTS

Below, embodiments of the present invention will be described in detail. It should be noted that the present invention should not be construed to be limited to the below-described specific embodiments, and can be modified in various manners to the extent that such modifications make it possible to achieve an object of the present invention.

A field-effect transistor is formed with functional materials such as a gate electrode, a gate insulating layer, a source electrode, a drain electrode, and a semiconductor layer, and such functional materials are arranged in various known aspects. As below-mentioned, the present invention includes a step of forming a semiconductor layer using a method controlled as below-mentioned, and the field-effect transistor is not limited to any particular aspect provided that the present invention can be applied in the aspect. Below, three typical aspects will be described. In addition, the present invention is extremely useful particularly to form two or more field-effect transistors on a substrate.

<Method of Producing Field-Effect Transistor (FET)>

(First Embodiment)

A method of producing an FET according to a first embodiment of the present invention is a method of producing a plurality of FETs on the surface of a substrate, and is a method including the steps (1a) to (1f).

(1a) a step of forming a gate electrode on the surface of a substrate.
(1b) a step of forming a gate insulating layer on the gate electrode.
(1c) a step of forming a source electrode and a drain electrode on the gate insulating layer.
(1d) a step of measuring a physical quantity based on one or more of the formed gate electrode, gate insulating layer, source electrode, and drain electrode.
(1e) a step of adjusting, on the basis of the measured physical quantity, the coating quantity of a semiconductor material to be applied between the source electrode and the drain electrode.
(1f) a step of applying the semiconductor material in the quantity adjusted in the step (1e) between the source electrode and the drain electrode to form a semiconductor layer.

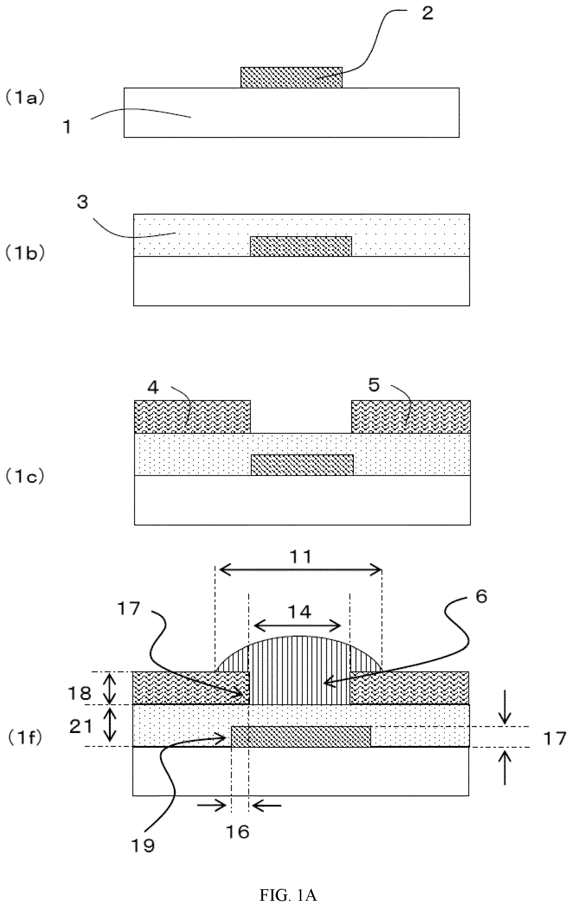

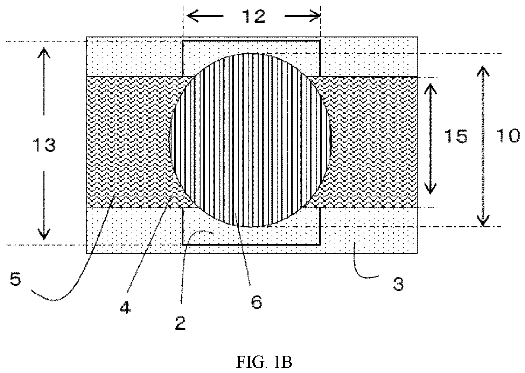

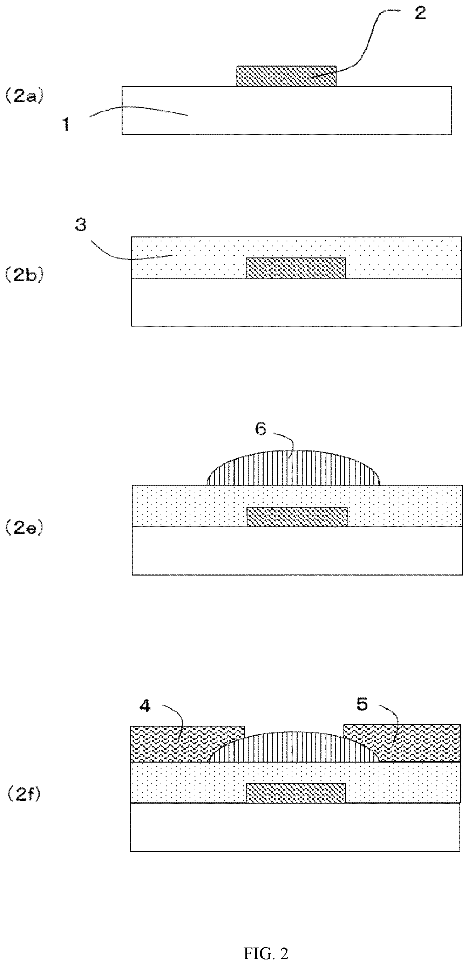

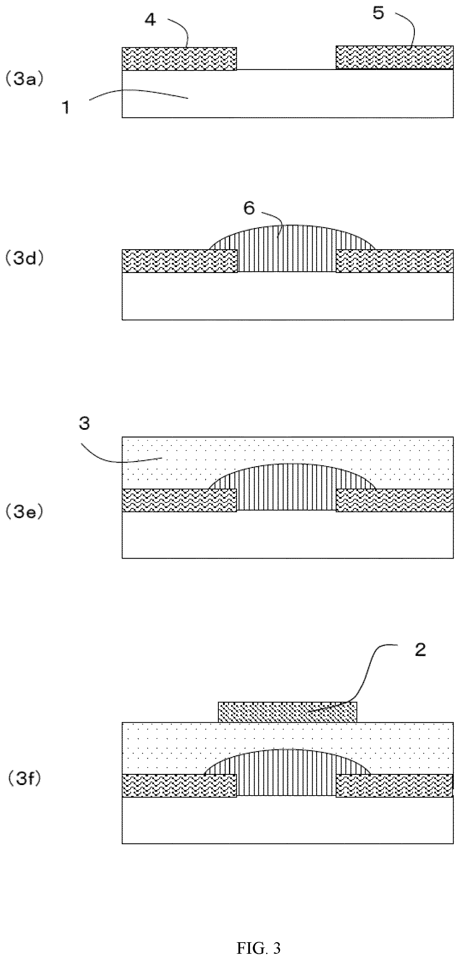

FIG. 1A is schematic sectional views depicting a method of producing an FET according to the first embodiment of the present invention. In addition, FIG. 1B is a schematic top view of an FET produced using the method. In this regard, FIG. 1A depicts one element for convenience of explanation, but it can be easily understood that the above-mentioned step can be carried out to produce a plurality of FETs concurrently (this equally applies to FIG. 2 and FIG. 3).

According to FIG. 1, (1a) a gate electrode 2 is formed on the surface of a substrate 1, (1b) a gate insulating layer 3 is formed so as to cover the gate electrode 2, and (1c) a source electrode 4 and a drain electrode 5 are formed on the gate insulating layer 3. Then, (1d) a physical quantity based on one or more of the formed gate electrode, gate insulating layer, source electrode, and drain electrode is measured, and (1e) the coating quantity of a semiconductor material to be applied between the source electrode and the drain electrode is adjusted on the basis of the measured physical quantity, although the description of these steps is omitted from FIG. 1A. Then, (1f) the semiconductor material is applied in the coating quantity adjusted in the step (1e) between the source electrode 4 and the drain electrode 5 to form a semiconductor layer 6.

In the first embodiment, the above-mentioned steps (1a) to (1f) are applied to each of a plurality of FETs to be formed on the surface of the substrate, thus making it possible to inhibit such a variation in the driving current value of the FET as is due to a variation generated in all or part of the steps of forming the gate electrode, gate insulating layer, source electrode, and drain electrode.

In the method of producing an FET according to the first embodiment, a step of forming a wiring for the gate electrode and a wiring for the source electrode and the drain electrode can further be provided besides the steps (1a) to (1f), although the description of the former step is omitted from FIG. 1A.

The method of forming an electrode in the steps (1a) and (1c) is not limited to any particular method provided that the method makes it possible to form an electrode, and examples of such methods include an inkjet method, printing method, ion plating coating method, resistance heating evaporation method, electron beam method, sputtering method, plating method, CVD method, and the like. Among these, a coating method is preferably used from the viewpoint of production cost, material usage efficiency, adaptability to a large area, and the like. In addition, for cases where a paste containing a binder and an electrical conductor is used as an electrode material, another example is a method in which the paste is applied to a substrate using a known technique such as a spin coating method, a blade coating method, a slit die coating method, a screen printing method, a bar coater method, a casting method, a transfer printing method, an immersion and withdrawal method, or the like, and dried using an oven, a hot plate, infrared rays, or the like. In addition, a method of forming an electrode pattern may be a method in which an electrode thin film formed by the above-described method is patterned into a desired form using a known photolithography method or the like, or may be a method in which a pattern is formed via a mask having a desired shape during the vapor deposition or sputtering of an electrode substance.

The method of producing a gate insulating layer in the step (1b) is not limited to any particular method provided that the method makes it possible to form an insulating layer, and examples thereof include a method in which a raw material composition is applied to a substrate having a gate electrode formed thereon, and is dried to obtain a coating film, which is heat-treated, if necessary. Examples of coating methods include known coating methods such as a spin coating method, blade coating method, slit die coating method, screen printing method, bar coater method, casting method, transfer printing method, immersion and withdrawal method, inkjet method, and the like. A temperature at which the coating film is heat-treated is preferably in the range of from 50 to 300°C.

A physical quantity to be measured in the step (1d) and based on one or more of a gate electrode, gate insulating layer, source electrode, and drain electrode is selected from physical quantities which influence the driving current value of an FET owing to: such a deviation in physical quantity from a design value as generated in all or part of the steps of forming a gate electrode, gate insulating layer, source electrode, and drain electrode; and ununiformity in physical quantity among the elements; that is, what are collectively referred to as a variation (generated in production processes). That is, finding a physical quantity related to the FET makes it possible to determine the driving current value which is characteristic of an FET. Thus, the driving current value of an FET varies because the physical quantity related to the FET deviates from a design value or does not become an equal physical quantity among the elements. To inhibit the characteristic variation of an FET, a deviation from a set value of physical quantity in each FET is evaluated so that how much the driving current value deviates from a predetermined value can be known, and to correct the amount of the deviation, it is only necessary that a physical quantity is corrected with respect to a reference value.

This will be more specifically described. The driving current value $I_d$ of an FET depends on the state of the semiconductor layer 6 between the source electrode 4 and the drain electrode 5, and, for example, is represented by the below-mentioned formula (1) and formula (2), as is known.

In the case of $V_d < V_g - V_{th}$,

$$I_d = (W / L) \cdot (\varepsilon_0 \cdot \varepsilon_r \cdot \mu/d) \cdot ((V_g - V_{th}) \cdot V_d + (1/2) \cdot V_d{}^2) \dots (1)$$

In the case of $V_d > V_g - V_{th}$,

$$I_d = (W / 2L) \cdot (\varepsilon_0 \cdot \varepsilon_r \cdot \mu/d) \cdot (V_g - V_{th})^2 \dots (2)$$

Here, $V_d$ represents a drain voltage, $V_g$ a gate voltage, $V_{th}$ a threshold voltage, $\varepsilon_0$ a dielectric constant of vacuum ($8.85 \times 10^{-12}$ F/m), $\varepsilon_r$ the relative dielectric constant of a gate insulating layer, W a channel width, L a channel length, d the thickness of a gate insulating layer, and $\mu$ a mobility.

According to the formula (1) and the formula (2), the driving current value $I_d$ of an FET depends on W, L, d, and the like. Because of this, examples of physical quantities to be measured include size, surface roughness, density, refractive index, and the like. With reference to FIG. 1A(1f) and FIG. 1B, specific examples of physical quantities include a channel width 10, channel length 11, gate electrode width 12, gate electrode length 13, spacing 14 between source electrode and drain electrode, drain electrode length 15 (here, a source electrode length is also applicable), overlapping portion length 16 between gate electrode and source electrode (here, an overlapping portion length between gate electrode and drain electrode is also applicable), thickness of gate electrode layer 17, gate electrode surface roughness, gate electrode density, gate electrode refractive index, thickness of source electrode layer 18 (here, thickness of drain electrode layer is also applicable), surface roughness of source electrode or drain electrode, density of source electrode or drain electrode, refractive index of source electrode or drain electrode, roughness of gate electrode edge 19, roughness of source electrode or drain electrode edge, thickness of gate insulating layer 21, gate insulating layer surface roughness, gate insulating layer density, gate insulating layer refractive index, and the like.

Among these, the gate electrode width 12, gate electrode length 13, spacing 14 between source electrode and drain electrode, drain electrode length 15, source electrode length, and thickness of gate insulating layer 21 can be measured in any step after formation of the gate electrode, gate insulating layer, source electrode, or drain electrode. Furthermore, these can be, for example, measured in an in-line manner, in a non-destructive manner, and in a short time, and thus, are preferable.

The width, length, spacing, and roughness of each of these can be measured using an optical microscope, scanning electron microscope (SEM), or the like. The thickness of layer can be measured using an atomic force microscope, an ellipsometric method, or the like. The refractive index can be measured using a spectroscopic ellipsometric method or the like. For the overlapping portion length between gate electrode and source electrode or drain electrode, the overlapping portion length between gate electrode 2 and source electrode 4 or drain electrode 5 can be measured using an SEM to observe the cross-sections shown in FIG. 1A. For the surface roughness, the surface roughness of an insulating layer or an electrode can be measured using a surface profilometer. The measurement method or measurement means is not limited as above-mentioned, and it is only necessary that the same method can be used to measure a physical quantity for a plurality of FETs and to calculate the amount of variation in physical quantity for each FET.

Here, as a measurement value, the absolute value of the above-mentioned physical quantity item to be measured may be measured, or the amount of deviation from a reference value (for example, a design value) of the above-mentioned measurement item may be measured.

In addition, in finding the coating quantity of a semiconductor material, the coating quantity of the semiconductor material may be adjusted on the basis of one physical quantity, or the coating quantity of the semiconductor material may be adjusted on the basis of two or more physical quantities.

In the step (1e), the coating quantity of a semiconductor material is adjusted on the basis of the absolute value of a physical quantity measured in the step (1d) or on the basis of the amount of deviation of a physical quantity from a reference value. This makes it possible to adjust the driving current value $I_d$ of an FET to a predetermined value. For example, in cases where a semiconductor layer is formed from carbon nanotubes, adjusting the coating quantity results in adjusting the amount of the carbon nanotubes in the semiconductor layer, specifically the total length of the carbon nanotubes present per 1 $\mu$m$^2$ of the semiconductor layer, thus making it possible to adjust the mobility $\mu$ in the above-mentioned formula (1) and formula (2), and adjust the driving current value $I_d$ of an FET to a predetermined value.

Here, to adjust the coating quantity, the absolute value of the coating quantity may be adjusted on the basis of the measured physical quantity, or the coating quantity may be adjusted with respect to a reference coating quantity on the basis of the amount of deviation of the measured physical quantity from a reference value. In addition, for the coating quantity, it is only necessary that the amount of coating is preliminarily determined in accordance with the specification of an FET in an experiment or the like so that the driving current value $I_d$ of the FET can become a predetermined value. Then, a coating step can be carried out in accordance with the determined amount. The thickness of a gate insulating layer is taken for example as follows: in cases where the coating quantity is determined experimentally, some samples having the same thickness as a gate insulating layer are produced, the coating quantity that affords a predetermined driving current is determined, and the relationship between the thickness of the insulating layer and the coating quantity is determined. Then, for example, in cases where the measured thickness d of the gate insulating layer is smaller than a reference value, the driving current value $I_d$ is larger than a predetermined value in accordance with the formula (1) and formula (2). This results in taking an approach for decreasing the coating quantity of a semiconductor layer to adjust the driving current value $I_d$ to a predetermined value. In another example in which the channel width W in an FET is 10% shorter than a reference value, the driving current value $I_d$ is 10% smaller than a predetermined value in accordance with the formula (1) and formula (2). This results in making an adjustment for increasing the coating quantity of a semiconductor layer to adjust the driving current value $I_d$ to a predetermined value. In cases where a semiconductor layer is formed from carbon nanotubes, a conceivable method is to increase the coating quantity to increase the amount of the carbon nanotubes in the semiconductor layer by 10%, thus adjusting the driving current value $I_d$ to a predetermined value. In this regard, the above-mentioned increase or decrease in the coating quantity means an increase or decrease in the total length of the carbon nanotubes present in the semiconductor layer, and such an increase or decrease makes it possible to adjust the driving current value $I_d$.

Examples of methods of forming a semiconductor layer in the step (1f) include known coating methods such as a spin coating method, a blade coating method, a slit die coating method, a screen printing method, a bar coater method, a casting method, a transfer printing method, an immersion and withdrawal method, and an inkjet method. Among these, one selected from the group consisting of an inkjet method, a dispenser method, and a spray method is preferable. Furthermore, an inkjet method is more preferable from the viewpoint of usage efficiency of raw materials. From these coating methods, a suitable method can be selected in accordance with the coating film characteristics to be obtained, such as coating film thickness control and orientation control. In addition, the formed coating film may be annealed in the atmosphere, under reduced pressure, or in an inert gas atmosphere (in a nitrogen or argon atmosphere).

(Example of More Efficient First Embodiment)

The first embodiment makes it possible to enhance the production efficiency in cases where a plurality of FETs are formed on a substrate, and thus, it is preferable that a substrate for a plurality of FETs is first allowed to undergo the steps (1a) to (1c) to produce, on the substrate, a plurality of structures including a gate electrode, gate insulating layer, source electrode, and drain electrode, that the step (1d) is carried out on each of the structures, and that, in the step (1f), each of the structures is coated in the coating quantity adjusted in the step (1e).

In this regard, in cases where the structures exhibit less variation in a given area, it is possible that one structure in the area is allowed to undergo the step (1d), and that in accordance with the physical quantity obtained from the step, the coating quantity for the structure is determined and applied to another structure in the area. This method causes a difference in the driving current value among the obtained transistor elements, but if the difference is within an allowable range from a design viewpoint, the number of structures to be measured can be decreased. Accordingly, for example, the method advantageously makes it possible to shorten the time required for production, and thus, is preferable. Furthermore, a structure to be used for measurement of a physical quantity is not limited to from an FET itself provided that such a structure is based on one or more of a gate electrode, gate insulating layer, source electrode, and drain electrode of an FET. For example, a test pattern formed for measurement of a physical quantity may be used as an item to be measured.

(Second Embodiment)

A method of producing an FET according to a second embodiment of the present invention is a method of producing a plurality of FETs on the surface of a substrate, and includes the following steps (2a) to (2f).

(2a) a step of forming a gate electrode on the surface of a substrate.
(2b) a step of forming a gate insulating layer on the gate electrode.
(2c) a step of measuring a physical quantity based on one or more of the formed gate electrode and gate insulating layer.
(2d) a step of adjusting, on the basis of the measured physical quantity, the coating quantity of a semiconductor material to be applied.
(2e) a step of applying the semiconductor material in the quantity adjusted in the step (2d) to form the semiconductor layer.
(2f) a step of forming a source electrode and a drain electrode.

In this regard, the steps (2a) to (2f) do not necessarily need to be in this order. For example, the step (2e) and the step (2f) may be in this order or may be in the reverse order. In addition, the step (2c) and the step (2d) may be carried out before the step (2b).

FIG. 2 is schematic sectional views depicting a method of producing an FET according to the second embodiment of the present invention. According to FIG. 2, (2a) a gate electrode 2 is formed on the surface of a substrate 1, and (2b) a gate insulating layer 3 is formed so as to cover the gate electrode 2. Then, (2c) a physical quantity based on one or more of the formed gate electrode and gate insulating layer is measured, and (2d) the coating quantity of a semiconductor material to be applied is adjusted on the basis of the measured physical quantity, although the description of these steps is omitted from FIG. 2. Then, (2e) the semiconductor material is applied in the coating quantity adjusted in the step (2d) to form a semiconductor layer 6, and (2f) a source electrode 4 and a drain electrode 5 are formed on the semiconductor layer 6.

Also in the second embodiment, the above-mentioned steps (2a) to (2f) are applied to each of a plurality of FETs formed on the surface of the substrate, thus making it possible to inhibit such a variation in the driving current value of the FET as is due to a variation generated in all or part of the steps of forming the gate electrode and gate insulating layer.

In addition, the more efficient embodiment described for the above-mentioned first embodiment may be applied also in the second embodiment. That is, it is preferable that a substrate for a plurality of FETs is first allowed to undergo the steps (2a) and (2b) to produce, on the substrate, a plurality of structures including a gate electrode and a gate insulating layer, that the step (2c) is carried out on each structure, that, in the step (2e), each structure is coated in the coating quantity adjusted in the step (2d), and that the step (2f) is subsequently carried out.

In the method of producing an FET according to the second embodiment, a step of forming a wiring for the gate electrode and a wiring for the source electrode and the drain electrode can further be provided besides the steps (2a) to (2f), although the description of the former step is omitted from FIG. 2.

As shown FIG. 2, an FET according to the second embodiment is different from one according to the first embodiment, and the semiconductor layer 6 is disposed below the source electrode and the drain electrode. The other structural components and the producing method and constituent members in each step are the same as in the first embodiment.

(Third Embodiment)

A method of producing an FET according to a third embodiment of the present invention is a method of producing a plurality of FETs on the surface of a substrate, and includes the following steps (3a) to (3f).

(3a) a step of forming a source electrode and a drain electrode on the surface of a substrate.
(3b) a step of measuring a physical quantity based on one or more of the formed source electrode and drain electrode.
(3c) a step of adjusting, on the basis of the measured physical quantity, the coating quantity of a semiconductor material to be applied.
(3d) a step of applying the semiconductor material in the quantity adjusted in the step (3c) to form a semiconductor layer.
(3e) a step of forming a gate insulating layer on the semiconductor layer.
(3f) a step of forming a gate electrode on the gate insulating layer.

FIG. 3 is schematic sectional views depicting a method of producing an FET according to the third embodiment of the present invention. According to FIG. 3, (3a) a source electrode 4 and a drain electrode 5 are formed on the surface of a substrate 1. Then, (3b) a physical quantity based on one or more of the formed source electrode and drain electrode is measured, and (3c) the coating quantity of a semiconductor material to be applied is adjusted on the basis of the measured physical quantity, although the description of these steps is omitted from FIG. 3. Then, (3d) the semiconductor material is applied in the coating quantity adjusted in the step (3c) to form a semiconductor layer 6, (3e) a gate insulating layer 3 is formed so as to cover the semiconductor layer 6, and (3f) a gate electrode 2 is formed on the gate insulating layer 3.

In the third embodiment, the above-mentioned steps (3a) to (3f) are applied to each of a plurality of FETs formed on the surface of the substrate, thus making it possible to inhibit such a variation in the driving current value of the FET as is due to a production variation generated in all or part of the steps of forming the source electrode and drain electrode.

In addition, the more efficient embodiment described for the above-mentioned first embodiment may be applied also in the third embodiment. That is, it is preferable that a substrate for a plurality of FETs is first allowed to undergo the step (3a) to produce, on the substrate, a plurality of structures including a source electrode and a drain electrode, that the step (3b) is carried out on each structure, that, in the step (3d), the semiconductor material in the coating quantity adjusted in the step (3c) is applied to each structure, and that the steps (3e) and (3f) are subsequently carried out.

In the method of producing an FET according to the third embodiment, a step of forming a wiring for the gate electrode and a wiring for the source electrode and the drain electrode can further be provided besides the steps (3a) to (3f), although the description of the former step is omitted from FIG. 3.

As shown FIG. 3, an FET according to the third embodiment is different from one according to the first embodiment, and the source electrode 4, drain electrode 5, and semiconductor layer 6 are disposed below the gate insulating layer 3. The other structural components and the producing method and constituent members in each step are the same as in the first embodiment.

(Other Embodiments)

As above, some examples have been described, and an embodiment of the present invention is not limited to these provided that the embodiment is characterized in that a physical quantity is measured on the basis of one or more of a gate electrode, a gate insulating layer, a source electrode, and a drain electrode, wherein the one or more is/are provided on a substrate, and that a semiconductor layer is formed, wherein to form the semiconductor layer, a semiconductor material is applied in the coating quantity determined on the basis of the physical quantity.

In this regard, an FET described in the above-mentioned embodiments can form a circuit in combination with various elements such as capacitor elements, resistance elements, diode elements, and inductor elements, which are not described here,.

(FET)

FETs according to a further embodiment, not forming part of the claimed invention, are a plurality of FETs having at least a gate electrode, a gate insulating layer, a semiconductor layer, a source electrode, and a drain electrode, and the semiconductor layer preferably contains carbon nanotubes. In addition, in cases where the semiconductor layer contains carbon nanotubes, the total length of the carbon nanotubes present per 1 $\mu m^2$ of the semiconductor layer has a correlation with the physical quantity based on one or more of the gate electrode, the gate insulating layer, the source electrode, and the drain electrode. Here, having a correlation means that a correlation coefficient between the above-mentioned physical quantity and the total length of carbon nanotubes present per 1 $\mu$m$^2$ of the semiconductor layer is 0.7 or more.

Examples of methods of calculating such a correlation coefficient include a method in which a correlation coefficient is determined using the below-mentioned formula (a), wherein x is the total length of carbon nanotubes present per 1 $\mu$m$^2$ of a semiconductor layer in each of 20 FETs that are randomly picked up, and y is a physical quantity based on one or more of a gate electrode, a gate insulating layer, a source electrode, and a drain electrode in each of the FETs.

$$\text{(covariance of x and y)} / ((\text{standard deviation of x}) \times (\text{standard deviation of y})) \quad (a)$$

Such an FET can be produced using a method of producing an FET according to the above-mentioned embodiments of the present invention.

Next, members constituting an FET that can be used in the present invention will be described in detail with reference to a specific example.

<Substrate>

A material to be used for a substrate is not limited to any particular one provided that at least that face of the material on which an electrode is disposed has insulating properties. A substrate that is suitably used contains a material, examples of which include, but are not limited to:

an inorganic material such as glass, sapphire, an alumina sintered material, a silicon wafer, or such a material the surface of which is covered with an oxide film; or
a resin such as a polyimide (PI) resin, polyester resin, polyamide resin, epoxy resin, polyamideimide resin, polyetherimide resin, polyetherketone resin, polysulfone resin, polyphenylene sulfide (PPS) resin, cycloolefin resin, or silicone resin.

<Gate Electrode, Source Electrode, Drain Electrode, and Wiring>

A material used for the gate electrode, source electrode, drain electrode, and wiring may be any electrically conductive material which can be generally used for electrodes. Examples of such electrically conductive materials include electrically conductive metal oxides such as tin oxide, indium oxide, indium tin oxide (ITO), and the like. Additional examples include inorganic electrically conductive materials, for example: metals such as platinum, gold, silver, copper, iron, tin, zinc, aluminium, indium, chromium, lithium, sodium, potassium, cesium, calcium, magnesium, palladium, molybdenum, amorphous silicon, and polysilicon; alloys of a plurality of metals selected from these; copper iodide and copper sulfide; and the like. Additional examples include: polythiophene, polypyrrole, polyaniline, and complexes of polyethylenedioxythiophene and polystyrene sulfonate; and electrically conductive polymers doped with iodine or the like to have higher electrical conductivity. Further examples include: carbon materials; materials containing an organic component and an electrical conductor; and the like.

Materials containing an organic component and an electrical conductor afford increased electrode flexibility, good adhesiveness maintained even in bending, and good electrical connection. Examples of organic components include, but are not limited particularly to, monomers, oligomers or polymers, photopolymerization initiators, plasticizers, leveling agents, surfactants, silane coupling agents, antifoaming agents, pigments, and the like. Among these, oligomers or polymers are preferable from the viewpoint of enhancing the bending resistance of an electrode. However, the electrically conductive materials for electrodes and wiring are not limited to these. These electrically conductive materials may be used singly, or a plurality of the materials may be laminated or used in mixture.

In addition, the width and thickness of an electrode and the spacing between electrodes (for example, a spacing between a source electrode and a drain electrode) can be freely set in accordance with the specification of an FET. For example, the width of each electrode is preferably set to 5 $\mu$m or more and 1 mm or less. The thickness of each electrode is preferably set to 0.01 $\mu$m or more and 100 $\mu$m or less. The spacing between a source electrode and a drain electrode is preferably set to 1 $\mu$m or more and 500 $\mu$m or less. However, these sizes are not limited to the above-mentioned ones.

Furthermore, the width and thickness of a wiring are freely determined. Specifically, the thickness of a wiring is preferably set to 0.01 $\mu$m or more and 100 $\mu$m or less. The width of a wiring is preferably set to 5 $\mu$m or more and 500 $\mu$m or less. However, these sizes are not limited to the above-mentioned ones.

<Gate Insulating Layer>

Examples of materials to be used for the gate insulating layer include, but are not limited particularly to: inorganic materials such as silicon oxide and alumina; organic polymer materials such as polyimide, polyvinyl alcohol, polyvinyl chloride, polyethylene terephthalate, polyvinylidene fluoride, polysiloxane, and polyvinylphenol (PVP); and mixtures of an inorganic material powder and an organic material. Among these, a material containing an organic compound having a bond between a silicon atom and a carbon atom is preferable from the viewpoint of adhesiveness to a substrate and an electrode. In addition, a material containing: an organic compound having a bond between a silicon atom and a carbon atom; and a metal compound having a bond between a metal atom and an oxygen atom is preferable.

The thickness of a gate insulating layer is preferably set to 0.05 $\mu$m or more and 5 $\mu$m or less, more preferably set to 0.1 $\mu$m or more and 1 $\mu$m or less. Setting the thickness of the layer within this range facilitates the formation of a uniform thin film.

The insulating layer may be a monolayer or multilayer. In addition, one layer may be composed of a plurality of insulating materials, or an insulating multilayer may be formed of a plurality of insulating materials that are laminated.

<Semiconductor Layer>

A material to be used for a semiconductor layer is not limited to any particular one provided that the material exhibits semiconductivity, and it is only necessary that a coating process can be applied to the material. Preferable examples of such materials include organic semiconductors and carbon materials.

In particular, carbon materials are preferable. Specific examples thereof include carbon nanotubes (hereinafter referred to as CNTs), graphene, fullerene, and the like, and CNTs are preferable from the viewpoint of suitability to a coating process and of high mobility.

As the CNT, any of a single-walled CNT in which a sheet of a carbon film (graphene sheet) is cylindrically rolled, a double-walled CNT in which two sheets of a graphene film are concentrically rolled, and a multi-walled CNT in which a plurality of sheets of a graphene film are concentrically rolled may be used, and a combination of two or more of these may also be used. From the viewpoint of exhibiting semiconductor characteristics, it is preferable to use single-walled CNTs, and in particular, it is more preferable that the single-walled CNTs contain semiconducting single-walled CNTs in an amount of 90 wt% or more. It is still more preferable that the single-walled CNTs contain semiconducting single-walled CNTs in an amount of 95 wt% or more.

The content ratio of the semiconducting single-walled CNTs can be calculated from the absorptive area ratio of a visible to near infrared absorption spectrum. CNTs can be obtained using a method such as an arc-discharge method, a chemical vapor deposition method (CVD method), a laser abrasion method, or the like.

Among these, CNTs are a preferable material to be used for semiconductor layers from the viewpoint of easiness of forming a semiconductor layer. Furthermore, a CNT having a conjugated polymer attached to at least a part of the surface of the CNT (hereinafter referred to as a CNT composite) is particularly preferable because such a CNT composite has superior dispersion stability in a solution and can afford low mobility. Here, the conjugated polymer refers to a compound the repeating unit of which has a conjugated structure and the polymerization degree of which is two or more.

The state in which a conjugated polymer is attached to at least a part of the surface of the CNT means the state in which the conjugated polymer covers a part or all of the surface of the CNT. It is presumed that the conjugated polymer can cover the CNT because the $\pi$ electron clouds derived from the conjugated structures are overlapped, thereby generating an interaction therebetween. Whether the CNT is covered with the conjugated polymer can be determined by whether the reflected color of the covered CNT approaches from the color of the uncovered CNT to the color of the conjugated polymer. Elemental analysis such as X-ray photoelectron spectroscopy (XPS) makes it possible to quantitatively identify the existence of attached matter and the mass ratio of the attached matter to the CNTs.

The CNT composite has a conjugated polymer attached to at least a part of the surface of the CNT, and thus, makes it possible to uniformly disperse the CNTs in a solution, without compromising the high electrical characteristics of the CNTs. In addition, a coating method using a dispersion liquid having CNTs uniformly dispersed therein makes it possible to form a CNT film having CNTs uniformly dispersed therein. This enables the film to achieve high semiconductor characteristics.

Examples of methods of attaching a conjugated polymer to a CNT include: (I) a method in which CNTs are added to a molten conjugated polymer, followed by mixing them; (II) a method in which CNTs are added to a solution of a conjugated polymer dissolved in a solvent, followed by mixing them; (III) a method in which a conjugated polymer is added to a dispersion liquid having CNTs previously dispersed in a solvent by means of ultrasonic waves or the like, followed by mixing them; (IV) a method in which a conjugated polymer and CNTs are poured into a solvent, followed by irradiating the resulting mixed system with ultrasonic waves to mix them; and the like. In the present invention, these methods may be combined.

In the present invention, the length of the CNT is preferably shorter than the spacing set between the source electrode and the drain electrode. The average length of the CNTs depends on the spacing between the source electrode and the drain electrode, but is preferably 2 $\mu$m or less, more preferably 0.5 $\mu$m or less. Commercially available CNTs have a length distribution, and in some cases, such CNTs include CNTs longer than the spacing between the source electrode and the drain electrode. Accordingly, it is preferable to add a step of making CNTs shorter than the spacing between the source electrode and the drain electrode. For example, a method in which the CNTs are cut into short fibers using an acid treatment with nitric acid, sulfuric acid, or the like or using an ultrasonic treatment, a freeze grinding method, or the like is effective. In addition, such a method combined with a method in which separation through a filter is carried out is more preferable from the viewpoint of increasing the purity.

In addition, the diameter of the CNT is, without particular limitation, preferably 0.5 nm or more and 100 nm or less, more preferably 1 nm or more and 50 nm or less.

Examples of the conjugated polymer to cover a CNT include polythiophene-based polymers, polypyrrole-based polymers, polyaniline-based polymers, polyacetylene-based polymers, poly-p-phenylene-based polymers, poly-p-phenylene vinylene-based polymers, thiophene-heteroarylene-based polymers having a thiophene unit and a heteroaryl unit in a repeating unit thereof, and the like. Two or more of these may be used. The polymers that can be used herein may be those in which the same monomer units are arranged, those in which different monomer units are block-copolymerized, random-copolymerized, or graft-polymerized, or the like.

In addition, for the semiconductor layer, the CNT composites and the organic semiconductor may be mixed and used. Dispersing the CNT composites uniformly in the organic semiconductor makes it possible to maintain the inherent characteristics of the organic semiconductor and at the same time, achieve high mobility.

In addition, the semiconductor layer may further include an insulating material. Examples of insulating materials to be used herein include, but are not limited particularly to: insulating material compositions according to the present invention; and polymer materials such as poly(methyl methacrylate), polycarbonate, and polyethylene terephthalate.

The semiconductor layer 6 may be a monolayer or multilayer, and preferably has a thickness of 1 nm or more and 200 nm or less, more preferably 100 nm or less. A thickness of the semiconductor layer within this range makes it easier to form a uniform thin film, and in addition, makes it possible to control an electric current that runs between the source and the drain and cannot be controlled by the gate voltage, and to further increase the on/off ratio of the FET. The thickness of the layer can be measured using an atomic force microscope, an ellipsometric method, or the like.

<Second Insulating Layer>

In the present invention, a second insulating layer may be formed on the opposite side of the semiconductor layer from the gate insulating layer. This enables the semiconductor layer to be protected from an external environment containing oxygen, moisture, and the like.

Specific examples of materials to be used for the second insulating layer include, but are not limited particularly to: inorganic materials such as silicon oxide and alumina; polymer materials such as polyimides and derivatives thereof, polyvinyl alcohols, polyvinyl chlorides, polyethylene terephthalate, polyvinylidene fluoride, polysiloxanes and derivatives thereof, and polyvinylphenols and derivatives thereof; mixtures of an inorganic material powder and a polymer material; and mixtures of an organic low molecular weight material and a polymer material.

Among these, a polymer material that can be produced using a coating method such as an inkjet method is preferably used. In particular, it is preferable, from the viewpoint of the uniformity of the insulating layer, to use polyfluoroethylene, polynorbornene, polysiloxane, polyimide, polystyrene, polycarbonate or a derivative thereof, polyacrylic acid derivative, polymethacrylic acid derivative, or a copolymer containing any of them.

The second insulating layer preferably has a thickness of 50 nm or more and 10 $\mu$m or less, more preferably 100 nm or more and 3 $\mu$m or less. The second insulating layer may be a monolayer or multilayer. In addition, one layer may be formed out of a plurality of insulating materials, or a plurality of insulating materials may be laminated into a multilayer.

Examples of methods that can be used to form the second insulating layer include, but are not limited particularly to, dry methods such as resistance heating evaporation, electron beaming, sputtering, and CVD, but it is preferable to use a coating method from the viewpoint of production cost and adaptability to a large area. Specific examples of coating methods that can be preferably used include a spin coating method, a blade coating method, a slit die coating method, a screen printing method, a bar coater method, a casting method, a transfer printing method, an immersion and withdrawal method, an inkjet method, a drop casting method, and the like. A coating method can be selected in accordance with the coating film characteristics to be obtained, such as coating film thickness control and orientation control.

In addition, it is an equally preferable aspect to cover a substrate with a material described for the above-mentioned second insulating layer so that the material can embed a gate electrode, a gate insulating layer, a semiconductor layer, a source electrode, and a drain electrode.

Reference Sings List

1      Substrate
2      Gate Electrode
3      Gate Insulating Layer
4      Source Electrode
5      Drain Electrode
6      Semiconductor Layer
10    Channel Width
11    Channel Length
12    Gate Electrode Width
13    Gate Electrode Length
14    Spacing between Source Electrode and Drain Electrode
15    Drain Electrode Length
16    Length of Overlapping Portion between Gate Electrode and Source Electrode
17    Thickness of Gate Electrode Layer
18    Thickness of Source Electrode layer
19    Gate Electrode Edge
21    Thickness of Gate Insulating Layer

**Claims**

1.   A method of producing a plurality of field-effect transistors on the surface of a substrate (1), comprising
forming a plurality of structures containing at least one or more of a gate electrode (2), a gate insulating layer (3), a source electrode (4), and a drain electrode (5), followed and **characterized by** the steps of:

     (A1) in each of said plurality of structures, measuring a physical quantity based on the one or more of the formed gate electrode (2), gate insulating layer (3), source electrode (4), and drain electrode (5);
     (B1) on the basis of the measured physical quantity in each of the structures, adjusting the coating quantity of a semiconductor material to be applied to each of the structures; and
     (C1) applying said semiconductor material in the adjusted coating quantity to each of the structures.

2.   The method of producing a plurality of field-effect transistors on the surface of a substrate (1) according to claim 1, comprising
forming a plurality of structures containing a gate electrode (2) and a gate insulating layer (3), followed by the steps of:

     (A2) in each of said plurality of structures, measuring a physical quantity based on the one or more of the formed gate electrode (2) and gate insulating layer (3);
     (B2) on the basis of the measured physical quantity in each of the structures, adjusting the coating quantity of a semiconductor material to be applied to each of the structures;
     (C2) applying said semiconductor material in the adjusted coating quantity to each of the structures; and
     (D2) forming a source electrode (4) and a drain electrode (5).

3.   The method of producing a plurality of field-effect transistors on the surface of a substrate (1) according to claim 1, comprising
forming a plurality of structures containing a source electrode (4) and a drain electrode (5), followed by the steps of:

     (A3) in each of said plurality of structures, measuring a physical quantity based on the one or more of the formed source electrode (4) and drain electrode (5);
     (B3) on the basis of the measured physical quantity in each of the structures, adjusting the coating quantity of a semiconductor material to be applied to each of the structures;
     (C3) applying said semiconductor material in the adjusted coating quantity to each of the structures; and
     (D3) forming a gate electrode (2) and a gate insulating layer (3).

4.   The method of producing field-effect transistors according to any one of claims 1 to 3, wherein the step of adjusting the coating quantity is a step of adjusting the coating quantity of the semiconductor material for each of the plurality of field-effect transistors with respect to a reference coating quantity and on the basis of the amount of deviation of the measured physical quantity from a reference value.

5.   The method of producing field-effect transistors according to any one of claims 1 to 4,

   wherein the substrate (1) is sectioned into one or more regions each having a plurality of the structures,
   the step of measuring the physical quantity is carried out on one of the structures in the region, and
   the step of applying the semiconductor material is a step of applying the semiconductor material in the adjusted coating quantity to all the structures in the region.

6.   The method of producing field-effect transistors according to any one of claims 1 to 5, wherein the physical quantity is any one or more selected from the group consisting of a gate electrode width (12), a gate electrode length (13), a spacing (14) between a source electrode (4) and a drain electrode (5), a source electrode length, a drain electrode length (15), and a gate insulating layer (3) thickness (17).

7.   The method of producing field-effect transistors according to any one of claims 1 to 6, wherein the semiconductor material contains at least one selected from an organic semiconductor(s), carbon nanotubes, a graphene(s), and a fullerene(s).

**Patentansprüche**

1.   Verfahren zur Herstellung einer Vielzahl von Feldeffekttransistoren auf der Oberfläche eines Substrats (1), umfassend
   Bilden einer Vielzahl von Strukturen, die eine Gate-Elektrode (2) und/oder eine Gate-Isolierschicht (3) und/oder eine Source-Elektrode (4) und/oder eine Drain-Elektrode (5) umfassen, gefolgt von und **gekennzeichnet durch** die folgenden Schritte:

   (A1) in jeder der Vielzahl von Strukturen, Messen einer physikalischen Größe auf Grundlage der gebildeten Gate-Elektrode (2) und/oder der Gate-Isolierschicht (3) und/oder der Source-Elektrode (4) und/oder der Drain-Elektrode (5);
   (B1) auf Grundlage der gemessenen physikalischen Größe in jeder der Strukturen, Anpassen der Beschichtungsmenge eines Halbleitermaterials, das auf jede der Strukturen aufgebracht werden soll; und
   (C1) Aufbringen des Halbleitermaterials in der angepassten Beschichtungsmenge auf jede der Strukturen.

2.   Verfahren zur Herstellung einer Vielzahl von Feldeffekttransistoren auf der Oberfläche eines Substrats (1) nach Anspruch 1, umfassend
   Bilden einer Vielzahl von Strukturen, die eine Gate-Elektrode (2) und eine Gate-Isolierschicht (3) enthalten, gefolgt von den folgenden Schritten:

   (A2) in jeder der Vielzahl von Strukturen, Messen einer physikalischen Größe auf Grundlage der gebildeten Gate-Elektrode (2) und/oder der Gate-Isolierschicht (3);
   (B2) auf Grundlage der gemessenen physikalischen Größe in jeder der Strukturen, Anpassen der Beschichtungsmenge eines Halbleitermaterials, das auf jede der Strukturen aufgebracht werden soll;
   (C2) Aufbringen des Halbleitermaterials in der angepassten Beschichtungsmenge auf jede der Strukturen; und
   (D2) Bilder einer Source-Elektrode (4) und einer Drain-Elektrode (5).

3.   Verfahren zur Herstellung einer Vielzahl von Feldeffekttransistoren auf Grundlage der Bildung einer Vielzahl von Strukturen, die eine Source-Elektrode (4) und eine Drain-Elektrode (5) enthalten, gefolgt von den folgenden Schritten:

   (A3) in jeder der Vielzahl von Strukturen, Messen einer physikalischen Größe auf Grundlage der gebildeten Source-Elektrode (4) und/oder Drain-Elektrode (5);
   (B3) auf Grundlage der gemessenen physikalischen Größe in jeder der Strukturen, Anpassen der Beschichtungsmenge eines Halbleitermaterials, das auf jede der Strukturen aufgebracht werden soll;
   (C3) Aufbringen des Halbleitermaterials in der angepassten Beschichtungsmenge auf jede der Strukturen; und
   (D3) Bilder einer Gate-Elektrode (2) und/oder einer Gate-Isolierschicht (3).

**4.** Verfahren zur Herstellung von Feldeffekttransistoren nach einem der Ansprüche 1 bis 3, wobei der Schritt des Anpassens der Beschichtungsmenge ein Schritt des Anpassens der Beschichtungsmenge des Halbleitermaterials für jeden der Vielzahl von Feldeffekttransistoren in Bezug auf eine Referenzbeschichtungsmenge und auf Grundlage der Höhe der Abweichung der gemessenen physikalischen Größe von einem Referenzwert ist.

**5.** Verfahren zur Herstellung von Feldeffekttransistoren nach einem der Ansprüche 1 bis 4,

wobei das Substrat (1) in einen oder mehrere Bereiche unterteilt ist, die jeweils eine Vielzahl von Strukturen aufweisen,
der Schritt der Messung der physikalischen Größe an einer der Strukturen in dem Bereich durchgeführt wird, und
der Schritt des Aufbringens des Halbleitermaterials ein Schritt des Aufbringens des Halbleitermaterials in der angepassten Beschichtungsmenge auf alle Strukturen in dem Bereich ist.

**6.** Verfahren zur Herstellung von Feldeffekttransistoren nach einem der Ansprüche 1 bis 5, wobei die physikalische Größe eine oder mehrere Größen ist, die aus der Gruppe ausgewählt sind, die aus der Breite (12) der Gate-Elektrode, der Länge (13) der Gate-Elektrode, dem Abstand (14) zwischen der Source-Elektrode (4) und der Drain-Elektrode (5), der Länge der Source-Elektrode, der Länge (15) der Drain-Elektrode und der Dicke (17) der Gate-Isolierschicht (3) besteht.

**7.** Verfahren zur Herstellung von Feldeffekttransistoren nach einem der Ansprüche 1 bis 6, wobei das Halbleitermaterial zumindest eines ausgewählt aus einem organischen Halbleiter(n), Kohlenstoff-Nanoröhren, Graphen und Fulleren enthält.

**Revendications**

**1.** Procédé de production d'une pluralité de transistors à effet de champ sur la surface d'un substrat (1), comprenant la formation d'une pluralité de structures contenant au moins une ou plusieurs parmi une électrode de grille (2), une couche isolante de grille (3), une électrode de source (4) et une électrode de drain (5), suivie et **caractérisée par** les étapes de :

(A1) dans chacune de ladite pluralité de structures, mesure d'une grandeur physique sur la base de la ou des plusieurs parmi l'électrode de grille (2), la couche isolante de grille (3), l'électrode de source (4) et l'électrode de drain (5) formées ;
(B1) sur la base de la grandeur physique mesurée dans chacune des structures, réglage de la quantité de revêtement d'un matériau semi-conducteur à appliquer à chacune des structures ; et
(C1) application dudit matériau semi-conducteur dans la quantité de revêtement réglée à chacune des structures.

**2.** Procédé de production d'une pluralité de transistors à effet de champ sur la surface d'un substrat (1) selon la revendication 1, comprenant
la formation d'une pluralité de structures contenant une électrode de grille (2) et une couche isolante de grille (3), suivie des étapes de :

(A2) dans chacune de ladite pluralité de structures, mesure d'une grandeur physique sur la base de la ou des plusieurs parmi l'électrode de grille (2) et la couche isolante de grille (3) formées.
(B2) sur la base de la grandeur physique mesurée dans chacune des structures, réglage de la quantité de revêtement d'un matériau semi-conducteur à appliquer à chacune des structures ;
(C2) application dudit matériau semi-conducteur dans la quantité de revêtement réglée à chacune des structures, et
(D2) formation d'une électrode de source (4) et d'une électrode de drain (5).

**3.** Procédé de production d'une pluralité de transistors à effet de champ sur la surface d'un substrat (1) selon la revendication 1, comprenant
la formation d'une pluralité de structures contenant une électrode de source (4) et une électrode de drain (5), suivie des étapes de :

(A3) dans chacune de ladite pluralité de structures, mesure d'une grandeur physique sur la base de la ou des plusieurs parmi l'électrode de source (4) et l'électrode de drain (5) formées ;

(B3) sur la base de la grandeur physique mesurée dans chacune des structures, réglage de la quantité de revêtement d'un matériau semi-conducteur à appliquer à chacune des structures ;

(C3) application dudit matériau semi-conducteur dans la quantité de revêtement réglée à chacune des structures, et

(D3) formation d'une électrode de grille (2) et d'une couche isolante de grille (3).

4. Procédé de production de transistors à effet de champ selon l'une quelconque des revendications 1 à 3, dans lequel l'étape de réglage de la quantité de revêtement est une étape de réglage de la quantité de revêtement du matériau semi-conducteur pour chacun de la pluralité de transistors à effet de champ par rapport à une quantité de revêtement de référence et sur la base du degré d'écart de la grandeur physique mesurée par rapport à une valeur de référence.

5. Procédé de production de transistors à effet de champ selon l'une quelconque des revendications 1 à 4,

dans lequel le substrat (1) est divisé en une ou plusieurs régions ayant chacune une pluralité des structures, l'étape de mesure de la grandeur physique est réalisée sur l'une des structures dans la région, et l'étape d'application du matériau semi-conducteur est une étape d'application du matériau semi-conducteur dans la quantité de revêtement réglée à toutes les structures dans la région.

6. Procédé de production de transistors à effet de champ selon l'une quelconque des revendications 1 à 5, dans lequel la grandeur physique est l'une quelconque ou plusieurs choisies dans le groupe constitué par une largeur d'électrode de grille (12), une longueur d'électrode de grille (13), un espacement (14) entre une électrode de source (4) et une électrode de drain (5), une longueur d'électrode de source, une longueur d'électrode de drain (15) et une épaisseur (17) de couche isolante de grille (3).

7. Procédé de production de transistors à effet de champ selon l'une quelconque des revendications 1 à 6, dans lequel le matériau semi-conducteur contient au moins l'un choisi parmi un/des semi-conducteur(s) organique(s), des nanotubes de carbone, un/des graphène(s) et un/des fullerène(s).

FIG. 1A

FIG. 1B

（2a）

（2b）

（2e）

（2f）

FIG. 2

FIG. 3

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2009139339 A1
- JP 2006261423 A
- JP 2012212722 A

**Non-patent literature cited in the description**

- Fabrication of Thin-Film Transistor Integrated Circuits on Flexible Substrate by Transfer Technique of Carbon Nanotube Network Using Poly(vinyl alcohol). **SATOSHI ISHII et al.** JAPANESE JOURNAL OF APPLIED PHYSICS. JAPAN SOCIETY OF APPLIED PHYSICS, 01 October 2013, vol. 52, 108001-1